(19) Europäisches Patentamt
European Patent Office
Office européen des brevets

(11) **EP 2 019 431 A2**

(12) **EUROPÄISCHE PATENTANMELDUNG**

(43) Veröffentlichungstag:
**28.01.2009 Patentblatt 2009/05**

(51) Int Cl.:
**H01L 27/144** *(2006.01)* **H01L 31/0216** *(2006.01)*
**H01L 31/147** *(2006.01)* *H01L 31/153* *(2006.01)*

(21) Anmeldenummer: **08012446.4**

(22) Anmeldetag: **10.07.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **25.07.2007 DE 102007034782**

(71) Anmelder: **ATMEL Germany GmbH**
**74072 Heilbronn (DE)**

(72) Erfinder:
• **Kruck, Achim**
**74629 Pfedelbach (DE)**
• **Waible, Hans-Peter**
**74223 Flein (DE)**

(74) Vertreter: **Müller, Wolf-Christian**
**Koch Müller Patentanwaltsgesellschaft mbH**
**Maaßstrasse 32/1**
**69123 Heidelberg (DE)**

(54) **Lichtdetektor mit angepasster Empfindlichkeit für verschiedene Wellenlängenbereiche und Verfahren zum Herstellen so eines Halbleiterbauelements**

(57) Die Erfindung betrifft ein Halbleiterbauelement (10) mit einem integrierten Schaltkreis, der zumindest einen mit einer siliziumhaltigen Beschichtung (32,34,36), insbesondere einer Beschichtung aus Siliziumnitrid oder Siliziumdioxid, versehenen Lichtdetektor (14,16,18) aufweist.

Erfindungsgemäß ist vorgesehen, dass eine Schichtstärke der siliziumhaltigen Beschichtung (32,34,36), insbesondere der Beschichtung aus Siliziumnitrid oder Siliziumdioxid, derart gewählt ist, dass eine vorgebbare, schmalbandig wellenlängenselektive Transmission von Lichtwellen, insbesondere von Lichtwellen in einem Wellenlängenbereich von 300 nm bis 850 nm, erzielbar ist.

Fig. 2

EP 2 019 431 A2

**Beschreibung**

Die vorliegende Erfindung betrifft ein Halbleiterbauelement mit einem integ-rierten Schaltkreis, der zumindest einen mit einer siliziumhaltigen Beschichtung, insbesondere einer Beschichtung aus Siliziumnitrid oder Siliziumdioxid, versehenen Lichtdetektor aufweist, sowie eine Beleuchtung für Matrixbildschirme und ein Verfahren zum Herstellen eines Halbleiterbauelements.

Aus der US 4,131,488 ist ein als Fotodiode ausgeführter Lichtdetektor bekannt, der mit einer Antireflex-Beschichtung versehen ist, um einen vorteilhaften Wirkungsgrad zwischen dem auf die Oberfläche der Fotodiode einfallenden Licht und dem von der Fotodiode beeinflussbaren elektrischen Strom zu gewährleisten. Dadurch kann eine hohe Empfindlichkeit der Fotodiode für das einfallende Licht erzielt werden. Die Antireflex-Beschichtung ist als Schichtaufbau aus Siliziumdioxid und Siliziumnitrid verwirklicht und ermöglicht eine breitbandige Transmission von Lichtwellen unterschiedlicher Wellenlängen auf die aktive Oberfläche der Fotodiode, so dass nahezu unabhängig von der Zusammensetzung des einfallenden Lichts ein hoher Wirkungsgrad gewährleistet ist.

Aus der DE 40 19 853 C2 ist eine Halbleiter-Fotodiode mit Antireflex-Beschichtung für den Einsatz in optischen Messgeräten zur Messung von Lichtleistung bekannt. Dabei wird ein zumindest annähernd konstanter spektraler Gesamt-Umsetzfaktor angestrebt, so dass alle eintreffenden Lichtstrahlen mit unterschiedlichen Wellenlängen im Wesentlichen zu einem identischen Signal der Halbleiter-Fotodiode führen.

Die Aufgabe der Erfindung besteht darin, ein Halbleiterbauelement mit einem Lichtdetektor bereitzustellen, der bei einfacher Aufbauweise für eine Detektion eines oder mehrerer schmalbandiger Wellenlängenbereiche ausgebildet ist.

Diese Aufgabe wird durch ein Halbleiterbauelement der eingangs genannten Art gelöst, bei dem eine Schichtstärke der siliziumhaltigen Beschichtung, insbesondere der Beschichtung aus Siliziumnitrid oder Siliziumdioxid, derart gewählt ist, dass eine vorgebbare, schmalbandig wellenlängenselektive Transmission von Lichtwellen, insbesondere von Lichtwellen in einem Wellenlängenbereich von 400 nm bis 850 nm, erzielbar ist. Die vorzugsweise aus Siliziumnitrid ($Si_3N_4$) hergestellte siliziumhaltige Beschichtung wird bei der Herstellung von Halbleiterbauelementen, insbesondere in CMOS-Prozessen, standardmäßig als Passivierungsschicht und als Antireflexschicht eingesetzt und weist eine Brechzahl von ungefähr n =1,95 auf. Alternativ kann Siliziumdioxid ($SiO_2$) als siliziumhaltige Beschichtung verwendet werden. Die Schichtstärke der Beschichtung bestimmt das Verhalten der durch die Beschichtung hindurchtretenden Lichtstrahlen, die je nach gewählter Schichtstärke und Wellenlänge durch konstruktive bzw. destruktive Interferenz verstärkt bzw. bedämpft werden. Der Lichtdetektor weist üblicherweise eine durch seinen inneren Aufbau physikalisch bedingte wellenlängenabhängige Empfindlichkeit auf. Die Beschichtung kann hinsichtlich ihrer Dicke derart abgestimmt werden, dass der Lichtdetektor in einem oder in mehreren vorgebbaren Wellenlängenbereichen einen hohen Wirkungsgrad zwischen dem einfallenden Licht und dem von der Fotodiode beeinflussten elektrischen Strom aufweist, während in anderen Wellenlängenbereichen ein geringerer Wirkungsgrad zwischen Licht und Strom vorliegt. Ein hoher Wirkungsgrad bedeutet hierbei, dass bereits bei einer geringen Änderung der Beleuchtungsstärke des einfallenden Lichts eine entsprechend starke Änderung des von der Fotodiode beeinflussten Stroms auftritt, während bei einem geringen Wirkungsgrad nur eine schwache Änderung des beeinflussten Stroms auftritt. Dazu wird die Schichtstärke der Beschichtung derart gewählt, dass Licht mit einer erwünschten Wellenlänge in einem schmalbandigen Wellenlängenbereich mit einer hohen Transmission durch die Beschichtung hindurchtreten kann. Licht mit Wellenlängen außerhalb dieses Wellenlängenbereichs wird teilweise oder vollständig an der Beschichtung reflektiert und trifft daher mit einer reduzierten Intensität auf den Lichtdetektor auf und hat damit einen geringere oder keinen Anteil bei der Beeinflussung eines Stromflusses durch den Lichtdetektor. Vorzugsweise weist die Beschichtung eine Transmission größer 50 Prozent für ein Wellenlängenband mit einer Bandbreite von 50 nm, vorzugsweise 30 nm, besonders bevorzugt 20 nm, insbesondere 15 nm, auf. Lichtstrahlen mit Wellenlängen, die benachbart außerhalb dieses Wellenlängenbands liegen, dringen hingegen mit einer Transmission kleiner 50 Prozent durch die Beschichtung bis zum Lichtdetektor durch. Somit wird die gewünschte schmalbandige Wellenlängenselektivität erreicht.

In Ausgestaltung der Erfindung ist vorgesehen, dass die siliziumhaltige Beschichtung als homogene Einstoffschicht, insbesondere mit einer Schichtdicke im Bereich zwischen 50 nm und 4000 nm, vorzugsweise mit einer Schichtdicke, die einem ganzzahligen Vielfachen eines Viertels der Wellenlänge der zu transmittierenden Lichtwellen entspricht, ausgeführt ist. Damit kann ein einfacher und kostengünstiger Aufbau eines Halbleiterbauelements verwirklicht werden, da mit der siliziumhaltigen Beschichtung neben der Passivierung des Halbleiterbauelements auch die für die schmalbandige wellenlängenselektive Lichtdetektion des Lichtdetektors notwendigen Voraussetzungen geschaffen werden. Die Beschichtung wird als einlagige Schicht bzw. als mehrlagige Schichtfolge jeweils gleichartiger Materialschichten auf den integrierten Schaltkreis aufgebracht, wobei lediglich produktionstechnisch bedingte Eigenschaftsgradienten zwischen den Schichten auftreten, die Beschichtung insgesamt aber als homogen zu betrachten ist. Erfindungsgemäß ist vorgesehen, dass alle Schichten der Beschichtung chemisch zumindest nahezu identisch und zumindest im Wesentlichen frei von vorgegebenen Eigenschaftsgradienten sind. Vorzugsweise ist eine Schichtdicke t [m] der siliziumhaltigen Beschichtung vorgesehen, die einem ganzzahligen Vielfachen n [-] eines Viertels der Wellenlänge λ [m] der zu transmittierenden Lichtwellen entspricht, so dass die Schichtdicke der Beschichtung nach der folgenden Gleichung gewählt wird:

$$t = n* \lambda/4 \ [m].$$

um eine möglichst hohe Transmission der Lichtwellen mit der Wellenlänge λ auf den Lichtdetektor zu ermöglichen, während Lichtwellen mit abweichenden Wellenlängen mit geringerer Transmission auf dem Lichtdetektor eintreffen und überwiegend von der Beschichtung reflektiert werden.

In weiterer Ausgestaltung der Erfindung ist vorgesehen, dass die Schichtdicke der siliziumhaltigen Beschichtung derart gewählt ist, dass eine inhomogene Empfangscharakteristik des Lichtdetektors für unterschiedliche Lichtwellenlängen zumindest teilweise kompensierbar ist. Ein Lichtdetektor weist üblicherweise eine wellenlängenabhängige Empfindlichkeit auf. Typisch ist, dass der Lichtdetektor ein Empfindlichkeitsmaximum bei einer bestimmten Wellenlänge aufweist. Exemplarisch ist ein als CMOS-Detektor, Bipolar-Detektor, PN-Diode oder PIN-Diode ausgeführter Lichtdetektor für eine Lichtwellenlänge von 658 nm besonders empfindlich. Das heißt, dass diese Wellenlänge bei einer für alle Wellenlängen gleichen Bestrahlungsintensität den größten Stromfluss im Lichtdetektor bewirkt. Licht mit anderen Wellenlängen führt zu einem geringen Stromfluss im Lichtdetektor. Um eine zumindest nahezu identische Empfindlichkeit des Lichtdetektors für die Lichtwellenlänge 658 nm und für eine zweite Lichtwellenlänge zu erzielen, wird die Schichtdicke der siliziumhaitigen Beschichtung derart gewählt, dass eine Transmission für die zweite Lichtwellenlänge besonders hoch und für die Lichtwellenlänge 658 nm entsprechend niedriger ist. Dadurch wird erreicht, dass Licht mit der zweiten Wellenlänge den gleichen Stromfluss durch den Lichtdetektor wie Licht mit einer Wellenlänge von 658 nm hervorruft. In vorteilhafter Weise wird also die Schichtdicke der siliziumhaltigen Beschichtung derart gewählt, dass eine hohe Empfindlichkeit des Lichtdetektors für eine erste Wellenlänge (mittels einer geringen Transmission der Beschichtung für die erste Wellenlänge) an eine niedrige Empfindlichkeit des Lichtdetektors für eine zweite Wellenlänge (bei hoher Transmission der Beschichtung für die zweite Wellenlänge) angepasst wird und somit eine zumindest teilweise Kompensation der Empfindlichkeit des Lichtdetektors erreicht werden kann

Dies ist insbesondere für einen Einsatz des Halbleiterbauelements als Aufnehmer von Lichtstrahlen, die an optischen Speichermedien zum Auslesen von gespeicherten Informationen reflektiert werden, von Interesse. Hierfür wird vermehrt eine Abtastung des Speichermediums mit zwei Lichtquellen vorgesehen, die unterschiedliche Wellenlängen aufweisen. Dabei weist der Lichtdetektor idealerweise einen durch die angepasste Beschichtung erzielten, für beiden Lichtwellenlängen zumindest ähnlichen, vorzugsweise identischen, Wirkungsgrad auf.

In weiterer Ausgestaltung der Erfindung ist vorgesehen, dass in dem integrierten Schaltkreis zumindest zwei Lichtdetektoren vorgesehen sind, die Beschichtungen mit unterschiedlicher Schichtdicke zur Detektion von unterschiedlichen Lichtwellenlängen aufweisen. Durch die unterschiedlichen Schichtdicken der Beschichtung auf den vorzugsweise ansonsten technisch identisch ausgelegten Lichtdetektoren können diese für den Empfang von unterschiedlichen Lichtwellenlängen optimiert werden.

In weiterer Ausgestaltung der Erfindung ist vorgesehen, dass der integrierte Schaltkreis für eine Detektion eines Abstrahlungsspektrums einer aus mehreren Leuchtquellen, insbesondere Leuchtdioden, aufgebauten Leuchtquellenanordnung eingerichtet ist, die Licht in unterschiedlichen Wellenlängenbereichen abstrahlt. Durch eine selektive Ansteuerung der Leuchtquellen kann die Leuchtquellenanordnung Licht abstrahlen, das aus Bestandteilen mit unterschiedlicher spektraler Wellenlängenverteilung und unterschiedlicher Intensität zusammengesetzt ist. Damit kann Anpassung des Farbtons des von der Leuchtquellenanordnung ausgesendeten Lichts verwirklicht werden. Die Lichtdetektoren dienen dabei der Analyse des von der Leuchtquellenanordnung ausgesendeten Lichts, wobei jeder Lichtdetektor jeweils auf eine der von der Leuchtquellenanordnung abgestrahlten Wellenlänge abgestimmt ist. Zu diesem Zweck ist die Dicke der Beschichtung auf den Lichtdetektoren jeweils so gewählt, dass eine hohe Transmission für die zu detektierende Lichtwellenlänge bzw. für das schmalbandige Wellenlängenspektrum der jeweiligen Leuchtquelle gewährleistet ist. Die Lichtwellenlängen der anderen Leuchtquellen, die Licht in anderen spektralen Wellenlängenbereichen abgeben können, werden von der jeweiligen Beschichtung zumindest im Wesentlichen blockiert und führen nicht zu einer Beeinflussung des entsprechenden Lichtdetektors.

In weiterer Ausgestaltung der Erfindung ist vorgesehen, dass eine Steuereinrichtung zur Verarbeitung von Lichtdetektorsignalen vorgesehen ist. Diese ermöglicht eine unmittelbare Auswertung der von den Lichtdetektoren erzeugten Signale auf dem Halbleiterbaustein, ohne dass die Signale aufwendig verstärkt und an eine nachgelagerte, diskret ausgeführte elektronische Schaltung weitergeleitet werden müssen.

In weiterer Ausgestaltung der Erfindung ist vorgesehen, dass die Steuereinrichtung zur Ansteuerung von Leuchtquellen, insbesondere in Abhängigkeit von Signalen der Lichtdetektoren, ausgebildet ist. Dadurch kann eine Regelung der von den Leuchtquellen abgegebenen Lichtmenge und Lichtzusammensetzung vorgenommen werden, um beispielsweise bei geringstmöglichem Energieeinsatz eine farbtreue Beleuchtung sicherzustellen. Dies ist insbesondere bei Anzeigeeinrichtungen für batteriebetriebene Geräte von Interesse, die mit einer Vielzahl von Leuchtquellen, insbesondere Leuchtdioden, ausgestattet sind und bei denen ein geringer Stromverbrauch angestrebt ist. In Abhängigkeit von einem gewünschten Kontrast und einer gewünschten Helligkeit für die Anzeigeeinrichtung können die Leuchtquellen in einem breiten Intervall mit elektrischer Energie versorgt werden, wodurch sich zumindest graduelle Unterschiede in dem jeweils ausgesendeten Wellenlängenspektrum ergeben können. Um sicherzustellen, dass zu jedem Zeitpunkt eine vorteilhafte Farbzusammensetzung für die Anzeigeeinrichtung vorliegt, kann durch Abtastung der Leuchtquellen mit den Lichtdetektoren eine Analyse der Farbzusammensetzung der Anzeigeeinrichtung vorgenommen werden. Bei Überschreiten von vorgebbaren Grenzwerten für Farbabweichungen kann mit Hilfe der Steuereinrichtung eine Korrektur der Farbzusammensetzung durch Erhöhen oder Senken der Stromzufuhr zu den betreffenden Leuchtquellen erreicht werden. Somit können beispielsweise durch Temperaturschwankungen oder Alterungserscheinungen auftretende Farbabweichungen von organischen Leuchtdioden, Fluoreszenzanzeigen oder Flüssigkristallanzeigen ausgeglichen werden.

In weiterer Ausgestaltung der Erfindung ist vorgesehen, dass die zumindest zwei Lichtdetektoren unterschiedliche Schichtdicken der siliziumhaltigen Beschichtungen aufweisen, so dass sie unterschiedliche Empfindlichkeiten für auftreffende Lichtwellen aufweisen. Durch die Schichtdicke der Beschichtung auf den Lichtdetektoren wird anhand der dadurch bedingten Transmissioneigenschaften die Empfindlichkeit des jeweiligen Lichtdetektors mitbestimmt. Damit weist beispielsweise ein erster Lichtdetektor aufgrund der Dicke seiner Beschichtung eine hohe Empfindlichkeit für eine erste Wellenlänge auf, während ein zweiter Lichtdetektor aufgrund der Dicke seiner Beschichtung eine geringe Empfindlichkeit für die gleiche Wellenlänge aufweist. Für eine zweite Wellenlänge liegt hingegen eine umgekehrte Empfindlichkeitsverteilung vor. Die Dicke der zweiten Beschichtung ergibt sich aus der Dicke der ersten Beschichtung und einer selektiv auf den zweiten Lichtdetektor aufgebrachten zweiten Beschichtung. Bei einer Vielzahl von Lichtdetektoren mit unterschiedlichen Dicken der Beschichtungen können diese jeweils in aufeinanderfolgenden Schritten aufgebracht sein, so dass sich die dickste Beschichtung als Summe aller Beschichtungsdicken ergibt.

In weiterer Ausgestaltung der Erfindung ist vorgesehen, dass die Steuereinrichtung für eine Kompensation von Signalen eines Lichtdetektors mit breitbandiger Wellenlängenselektion anhand von Signalen wenigstens eines Lichtdetektors mit schmalbandiger Wellenlängenselektion ausgebildet ist. Da die Wellenlängenselektivität der Beschichtung nicht für jeden Wellenlängenbereich gleich ist, ist ein erster Lichtdetektor,'dessen Beschichtung auf eine erste Wellenlänge abgestimmt ist, für den Empfang von Licht aus einem schmalbandigen Wellenlängenspektrum eingerichtet. Exemplarisch ist der erste Lichtdetektor mit einer Beschichtung versehen, die eine Lichttransmission von mehr als 50 Prozent nur für Wellenlängen im Bereich von 10 nm um eine erste Hauptwellenlänge herum erlaubt. Ein zweiter Lichtdetektor, dessen Beschichtung auf eine andere Lichtwellenlänge abgestimmt ist, empfängt hingegen aufgrund der Charakteristik der hierfür vorgesehenen Beschichtung Licht aus einem breiteren Wellenlängenspektrum, bei dem gegebenenfalls auch ein Anteil von Licht derjenigen Wellenlängen enthalten ist, die auch von dem ersten Lichtdetektor empfangen werden. Exemplarisch ist der zweite Lichtdetektor mit einer Beschichtung versehen, die eine Lichttransmission von mehr als 50 Prozent für Wellenlängen in einem Bereich von 30 nm um eine zweite Hauptwellenlänge herum erlaubt. Dabei sind die erste und die zweite Hauptwellenlänge beispielsweise um eine Wellenlängendifferenz von 30 nm voneinander beabstandet. Erfindungsgemäß ist vorgesehen, den vom ersten Lichtdetektor ermittelten Anteil von Licht des ersten Wellenlängebereichs von dem Gesamtsignal des zweiten Lichtdetektors abzuziehen, um damit zu einem korrigierten Signal des zweiten Lichtdetektors zu gelangen, das dadurch eine verbesserte Aussage über die Lichtintensität in einem zweiten, schmalbandigeren Wellenlängenbereich zulässt.

Gemäß einem weiteren Aspekt der Erfindung ist eine Beleuchtungseinrichtung für Bildschirme, insbesondere für Matrixbildschirme, mit wenigstens einem Halbleiterbaustein nach einem der Ansprüche 1 bis 13 vorgesehen. Mit dem erfindungsgemäßen Halbleiterbaustein kann eine Beleuchtung oder Hinterleuchtung des Matrixbildschirms, der beispielsweise als Dünnschichttransitor-Monitor (TFT-Monitor) ausgeführt sein kann, überprüft und gegebenenfalls angepasst, vorzugsweise geregelt, werden.

Gemäß einem weiteren Aspekt der Erfindung ist ein Verfahren zur Herstellung eines integrierten Schaltkreises mit den folgenden Schritten vorgesehen: Aufbringen einer siliziumhaltigen Beschichtung, insbesondere einer Siliziumnitridschicht oder einer Siliziumdioxidschicht, mit einer ersten Schichtdicke auf eine Gruppe von Lichtdetektoren, selektives Aufbringen einer siliziumhaltigen Beschichtung, insbesondere einer Siliziumnitridschicht oder einer Siliziumdioxidschicht, mit einer zweiten Schichtdicke auf eine Untergruppe aus der Gruppe der Lichtdetektoren. Das Verfahren kann mit den bekannten fotolithographischen Strukturierungsmethoden durchgeführt werden und führt zu einer homogenen Einstoffschicht mit lokal angepasster, unterschiedlicher Schichtdicke. Dabei ist vorgesehen, dass die siliziumhaltige Beschichtung, insbesondere die Siliziumnitridschicht, durch einen PECVD-Verfahrensschritt (Plasma-Enhanced- Chemical- Vapour- Deposition- Verfahrensschritt) nach einer Passivierung der Oberfläche des integrierten Schaltkreises und einem Öffnen von optischen Fenstern oberhalb der Lichtdetektoren aufgebracht wird. Es kann auch vorgesehen sein, weitere siliziumhaltige Beschichtungen, insbesondere Schichten von Siliziumnitrid oder Siliziumdioxidschicht, mit gleichen oder unterschiedlichen Schichtdicken aufzubringen.

Weitere Vorteile und Merkmale der Erfindung ergeben sich aus den Ansprüchen sowie aus der nach-folgenden Beschreibung eines bevorzugten Ausfüh-rungsbeispiels, das anhand der Zeichnungen dargestellt ist. Dabei zeigt:

Fig. 1    eine Draufsicht auf ein Halbleiterbauelement mit einer Gruppe von Lichtdetektoren und einer Leuchtdiodenanordnung,

Fig. 2    eine Schnittansicht des Halbleiterbauelements gemäß der Fig. 1,

Fig. 3    eine schematische Schnittdarstellung einer Anordnung des Halbleiterbauelements gemäß der Fig. 1 und 2 an einer Leuchtdiodenanordnung,

Fig. 4    eine schematische Darstellung von Verlaufs-kurven eines Lichtdetektorpotentials in Abhän-gigkeit einer Schichtdicke einer Siliziumnitrid-beschichtung für zwei Lichtwellenlängen

Fig. 5    eine schematische Darstellung von Verlaufs-kurven eines Lichtdetektorpotentials in Abhän-gigkeit der Lichtwellenlänge für unterschiedli-che Schichtdicken der Siliziumnitridbeschich-tung.

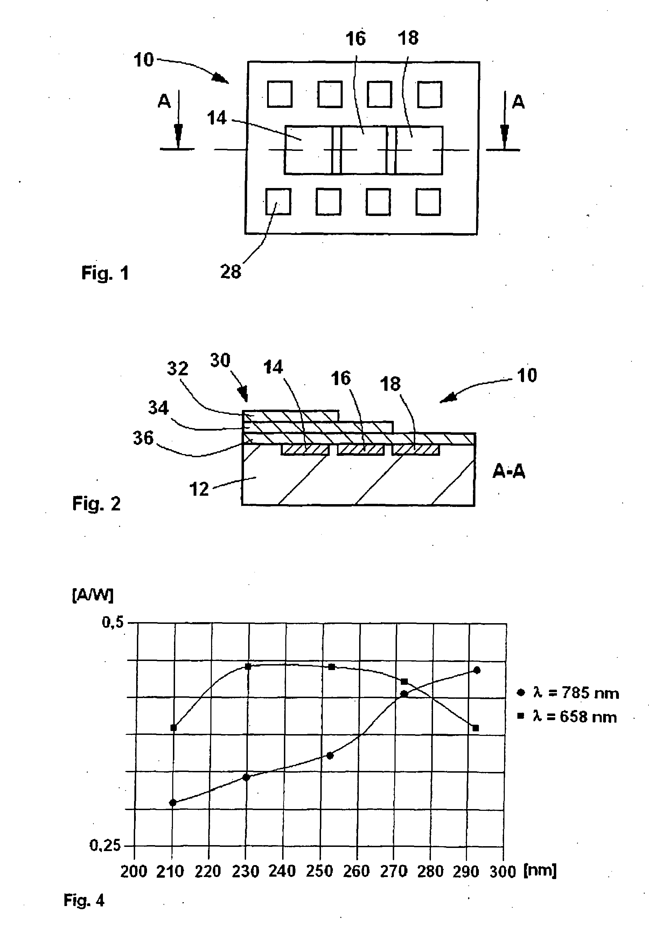

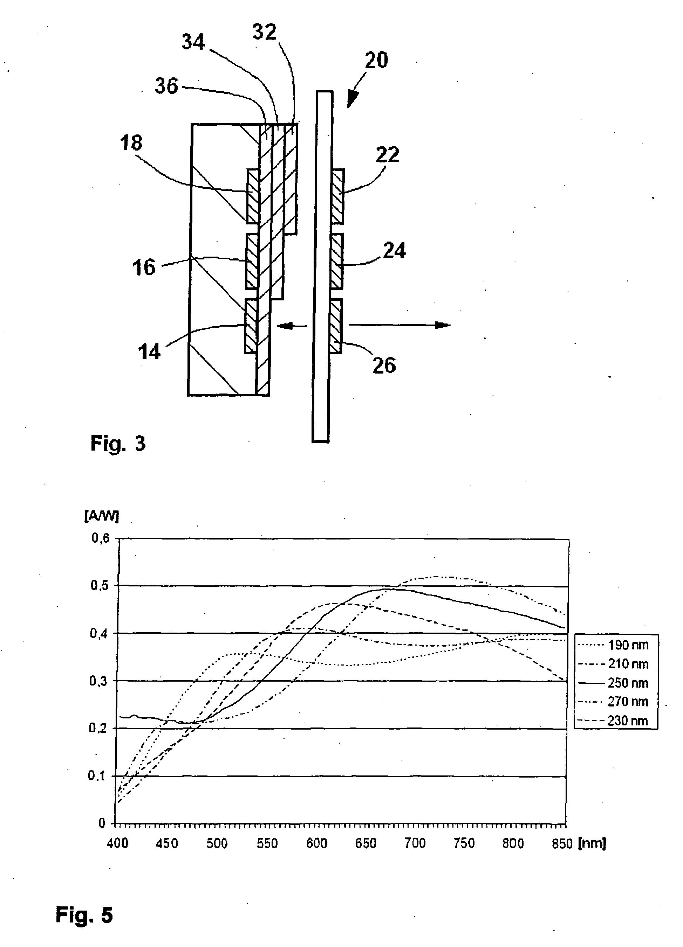

Ein in der Fig. 1 schematisch und nicht maßstäblich dargestelltes, als Multi-Chip-Modul (MCM) ausgeführtes Halbleiterbauelement 10 weist einen integrierten Schaltkreis auf, der auf einem Siliziumsubstrat 12 in Bi-CMOS-Technik (Complementary-Metal-Oxide-Semiconductor-Technik) aus mehreren, nicht näher dargestellten Schichten aufgebaut ist. Der integrierte Schaltkreis weist mehrere als Fotodioden 14, 16, 18 ausgeführte Lichtdetektoren auf, die bei dem Ausführungsbeispiel gemäß der Fig. 3 jeweils einer von drei Leuchtdioden 22, 24 und 26 einer Leuchtdiodenanordnung 20 zugeordnet sind. Weiterhin sind eine Reihe von Bondpads 28 für eine elektrische Ankopplung des integrierten Schaltkreises an eine nicht näher dargestellte elektronische Schaltung vorgesehen.

Die Fotodioden 14, 16 und 18 sind mit einer nicht näher dargestellten Steuereinrichtung verbunden, die ebenfalls Teil der integrierten Schaltung ist und die eine Auswertung von elektrischen Signalpegeln, die von den Fotodioden 14, 16, 18 bei Lichteinfall bewirkt werden, ermöglicht. Die Steuerschaltung ist auch mit den Leuchtdioden 22, 24, 26 elektrisch verbunden und ist für eine selektive Ansteuerung der Leuchtdioden 22, 24, 26 vorgesehen, die jeweils für die Aussendung von Lichtwellen mit unterschiedlichen Wellenlängen vorgesehen sind.

In der schematischen und nicht maßstäblichen Schnittdarstellung der Fig. 2 wird ein Schichtaufbau einer auf die integrierte Schaltung aufgebrachten Siliziumnitridschicht 30 näher dargestellt. Die Siliziumnitridschicht 30 ist aus drei Einzelschichten 32, 34 und 36 aufgebaut. Die dargestellte Schichtdicke der Einzelschichten 32, 34, 36 ist lediglich schematisch und nicht als beschränkend anzusehen. In der oberen Einzelschicht 32 ist im Bereich oberhalb der Fotodioden 16 und 18 eine fensterartige Ausnehmung vorgesehen, so dass der Fotodiode 16 nur zwei Einzelschichten 34, 36 der Siliziumnitridschicht zugeordnet sind. In der mittleren Einzelschicht 34 ist im Bereich oberhalb der Fotodiode 18 eine Ausnehmung vorgesehen, so dass der Fotodiode 18 lediglich eine Einzelschicht 36 zugeordnet ist.

Die Schichtdicke der Einzelschichten 32, 34 und 36 ist derart ausgewählt, dass die untere Einzelschicht 36 eine maximale Transmission für einen schmal-bandigen, ersten Wellenlängenbereich aufweist, wäh-rend die mittlere Einzelschicht 34 zusammen mit der unteren Einzelschicht 36 eine maximale Transmission für einen schmalbandigen, zweiten Wellenlängenbereich aufweist, der vom ersten Wellenlängenbereich beabstandet ist. Das heißt, dass der erste Wellenlängenbereich ein Wellenlängenintervall aufweist, das vom Wel-lenlängenintervall des zweiten Wellenlängebereichs der-art abweicht, dass das zweite Wellenlängenintervall nicht oder zu geringen Teilen in ersten Wellenlängenintervall enthalten ist.

Die Kombination aller drei Einzelschichten 32, 34 und 36 weist eine maximale Transmission für einen schmalbandigen, dritten Wellenlängenbereich auf, der vom ersten und vom zweiten Wellenlängenbereich beabstandet ist. Somit weist die Fotodiode 18 eine maximale Empfindlichkeit für den ersten Wellenlängenbereich auf, während die Fotodiode 16 eine maximale Empfindlichkeit für den zweiten Wellenlängenbereich aufweist. Die Fotodiode 14 weist eine maximale Empfindlichkeit für den dritten Wellenlängenbereich auf.

Damit kann eine Detektion einer Farbzusammensetzung, die sich aus dem Abstrahlverhalten der in Fig. 3 näher dargestellten Leuchtdioden 22, 24, 26 ergibt, mit Hilfe der Fotodioden 14, 16, 18 vorgenommen werden, deren jeweilige Signalpegel von der Steuereinrichtung ausgewertet werden. Exemplarisch ist vorgesehen, dass die Leuchtdioden 22, 24 und 26 gemäß der Darstellung der Fig. 3 eine nach rechts gerichtete Hauptabstrahlrichtung aufweisen, während in Richtung der Fotodioden 14, 16 und 14 lediglich ein Bruchteil der Lichtleistung abgestrahlt wird, wie dies durch die Pfeile schematisch dargestellt wird. Dennoch kann anhand der auf die Fotodioden 14, 16 und 18 eine Detektion der jeweiligen Abstrahlungsintensität der jeweils zugeordneten Leuchtdiode 22, 24 und 26 ermittelt werden.

Anhand der Auswertung der an den Fotodioden 14, 16 und 18 durch die Beleuchtung durch die Leuchtdioden 22, 24 und 26 auftretenden Signalpegel kann eine Ansteuerung der verschiedenen Leuchtdioden 22, 24 und 26 derart vorgenommen werden, dass diese eine aus mehreren Komponenten zusammengesetzte Lichtstrahlung mit einer gewünschten, von der Steuereinrichtung vorgebbaren Farbzusammensetzung abstrahlen.

Da die Wellenlängenselektivität der Einzelschichten 32, 34, 36 aufgrund von Produktionstoleranzen begrenzt ist, kann eine Kompensation der Signale der Fotodioden 14, 16, 18 vorgenommen werden. Zu diesem Zweck weist die Steuereinrichtung bei einer nicht dargestellten Ausführungsform der Erfindung eine mathematische Verarbeitung, z.B. eine analoge oder digitale Additions- bzw. Subtraktionsschaltung, das heißt eine angepasste Matrixschaltung, auf, die als Operationsverstärker verwirklicht sein kann. Damit kann anhand eines Signalpegels einer ersten Fotodiode, die nur für einen schmalbandigen ersten Wellenlängenbereich empfindlich ist, ein Signalpegel einer zweiten Fotodiode, deren Beschichtung eine geringere Trennschärfe aufweist und somit breitbandiger ist, korrigiert werden. Dies geschieht, indem der Signalpegel der ersten Fotodiode mit dem Signalpegel der zweiten Fotodiode verknüpft wird, so dass der entsprechende unerwünschte Wellenlängenanteil im Signalpegel der zweiten Fotodiode entfernt wird.

Bei dem Schaubild gemäß der Fig. 4 ist auf der horizontalen Achse die Schichtdicke [nm] der Siliziumnitridschicht aufgetragen, während auf der vertikalen Achse der Signalpegel [A/W] einer Fotodiode normiert auf eine optische Bestrahlungsstärke aufgetragen ist, dies wird auch als "Empfindlichkeit" oder "Responsivity" bezeichnet. Die mit den kreisförmigen Meßpunkten dargestellte Verlaufskurve wurde bei einer Lichtwellenlänge von 785 nm ermittelt. Die mit den quadratischen Meßpunkten dargestellte Verlaufskurve wurde bei einer Lichtwellenlänge von 658 nm ermittelt. Aus der Fig. 4 geht hervor, dass eine Kombination der Transmission der Siliziumnitridbeschichtung bei einer Schichtstärke von ca. 275 nm mit einer wellenlängenspezifischen, physikalisch bedingten Signalantwort der Fotodiode für beide Lichtwellenlängen identisch ist, so dass eine derart beschichtete Fotodiode einen identischen Stromfluss bei beiden Wellenlängen ermöglicht.

Bei dem Schaubild gemäß der Fig. 5 ist auf der horizontalen Achse die Wellenlänge [nm] des einfallenden Lichts aufgetragen, während auf der vertikalen Achse der Signalpegel einer Fotodiode normiert auf eine optische Bestrahlungsstärke aufgetragen [A/W] (Responsivity = Diodenstrom bezogen auf optische Leistung). Aus der Fig. 5 ist ersichtlich, dass für unterschiedliche Schichtstärken der Siliziumnitridbeschichtung deutlich voneinander abweichende Signalantworten in Form von unterschiedlichen elektrischen Strömen durch die Fotodiode ermittelt werden können, so dass durch eine Abstimmung der Fotodiode auf eine vorgebbare Wellenlänge durch Anpassung der Schichtstärke erreicht werden kann.

Ein derartiges Halbleiterbauelement kann auf bestehenden Produktionsanlagen für Halbleiterbauelemente gefertigt werden, da keine zusätzlichen Beschichtungsprozesse oder Beschichtungsmedien eingesetzt werden. Durch eine integrierte Gestaltung von einem oder mehreren Lichtdetektoren und einer Steuereinrichtung sowie gegebenenfalls einer oder mehrerer Leuchtdioden kann eine kompakte, lichtintensitätskompensierte Beleuchtungseinrichtung, insbesondere für die Beleuchtung von Matrixbildschirmen, geschaffen werden.

Bei einer nicht näher dargestellten Ausführungsform der Erfindung ist das Halbleiterbauelement auf einem Gallium-Arsenid-Substrat (GaAs) verwirklicht Damit könnte beispielsweise ein Wellenlängenmultiplexer hergestellt werden, bei dem drei exemplarische Wellenlängen (850 nm, 1310 nm, 1550 nm) durch eine erfindungsgemäße Filterbeschichtung selektiv auf drei Fotodioden geleitet werden, die jeweils eine Weiterverarbeitung der wellenlängenspezifischen Signale ermöglichen.

<u>Bezugszeichenliste</u>

| | |
|---|---|
| 10 | Halbleiterbauelement |
| 12 | Substrat |
| 14 | Fotodiode |
| 16 | Fotodiode |
| 18 | Fotodiode |
| 20 | Leuchtdiodenanordnung |
| 22 | Leuchtdiode |
| 24 | Leuchtdiode |
| 26 | Leuchtdiode |
| 28 | Bondpad |
| 30 | Siliziumnitridschicht |
| 32 | Einzelschicht (oben) |
| 34 | Einzelschicht (mitte) |
| 36 | Einzelschicht (unten) |

**Patentansprüche**

1. Halbleiterbauelement (10) mit einem integrierten Schaltkreis, der zumindest einen mit einer siliziumhaltigen Beschichtung (32, 34, 36), insbesondere einer Beschichtung aus Siliziumnitrid oder Siliziumdioxid, versehenen Lichtdetektor (14, 16, 18) aufweist, **dadurch gekennzeichnet, dass** eine Schichtstärke der siliziumhaltigen Beschichtung (32, 34, 36) derart gewählt ist, dass eine vorgebbare, schmalbandig wellenlängenselektive Transmission von Lichtwellen, insbesondere von Lichtwellen in einem Wellenlängenbereich von 400 nm bis 850 nm, erzielbar ist.

2. Halbleiterbauelement nach Anspruch 1, **dadurch gekennzeichnet, dass** die siliziumhaltige Beschichtung (32, 34, 36) als homogene Einstoffschicht, insbesondere mit einer Schichtdicke im Bereich zwischen 50 nm und 4000 nm, vorzugsweise mit einer Schichtdicke, die einem ganzzahligen Vielfachen eines Viertels der Wellenlänge der zu transmittierenden Lichtwellen entspricht, ausgeführt ist.

3. Halbleiterbauelement nach Anspruch 1 oder 2, **dadurch gekennzeich-net, dass** die Schichtdicke der siliziumhaltigen Beschichtung, insbesondere der Beschichtung aus Siliziumnitrid (32, 34 36), derart gewählt ist, dass eine inhomogene Empfangscharakteristik des Lichtdetektors (14, 16, 18) für unterschiedliche Lichtwellenlängen zumindest teilweise kompensierbar ist.

4. Halbleiterbauelement nach Anspruch 3, **dadurch gekennzeichnet, dass** die Schichtdicke der siliziumhaltigen Beschichtung, insbesondere der Beschichtung aus Siliziumnitrid (32, 34, 36), derart gewählt ist, dass eine hohe Empfindlichkeit des Lichtdetektors (14, 16, 18) für eine erste Wellenlänge mittels einer geringen Transmission der Beschichtung (32, 34, 36) für die erste Wellenlänge an eine niedrige Empfindlichkeit des Lichtdetektors (14, 16, 18) für eine zweite Wellenlänge bei hoher Transmission der Beschichtung (32, 34, 36) für die zweite Wellenlänge angepasst wird.

5. Halbleiterbauelement nach einem der vorhergehenden Ansprüche, **dadurch gekennzeichnet, dass** in dem integrierten Schaltkreis zumindest zwei Lichtdetektoren (14, 16, 18) vorgesehen sind, die siliziumhaltige Beschichtungen (32, 34, 36) mit unterschiedlicher Schichtdicke zur Detektion von unterschiedlichen Lichtwellenlängen aufweisen.

6. Halbleiterbauelement nach Anspruch 5, **dadurch gekennzeichnet, dass** die Lichtdetektoren (14, 16, 18) als Photodioden ausgebildet sind.

7. Halbleiterbauelement nach einem der vorhergehenden Ansprüche, **dadurch gekennzeichnet, dass** der integrierte Schaltkreis für eine Detektion eines Abstrahlungsspektrums einer aus mehreren Leuchtquellen (22, 24, 26), insbesondere Leuchtdioden, aufgebauten Leuchtquellenanordnung (20) eingerichtet ist, die Licht in unterschiedlichen Wellenlängenbereichen abstrahlt.

8. Halbleiterbauelement nach einem der vorhergehenden Ansprüche, **dadurch gekennzeichnet, dass** eine Steuereinrichtung zur Verarbeitung von Lichtdetektorsignalen vorgesehen ist.

9. Halbleiterbauelement nach Anspruch 8, **dadurch gekennzeichnet, dass** die Steuereinrichtung zur Ansteuerung von Leuchtquellen (22, 24, 26), insbesondere in Abhängigkeit von Signalen der Lichtdetektoren (14, 16, 18), ausgebildet ist.

10. Halbleiterbauelement nach Anspruch 5, **dadurch gekennzeichnet, dass** die zumindest zwei Lichtdetektoren (14, 16, 18) unterschiedliche Schichtdicken der siliziumhaltigen Beschichtung (32, 34, 36) aufweisen, so dass sie unterschiedliche Empfindlichkeiten für eintreffende Lichtwellen unterschiedlicher Wellenlängen aufweisen.

11. Halbleiterbauelement nach einem der Ansprüche 9 oder 10, **dadurch gekennzeichnet, dass** die Steuereinrichtung für eine Kompensation von Signalen eines Lichtdetektors (14, 16, 18) mit breitbandiger Wellenlängenselektion anhand von Signalen wenigstens eines Lichtdetektors (14, 16, 18) mit schmalbandiger Wellenlängenselektion ausgebildet ist.

12. Beleuchtungseinrichtung für Bildschirme, insbesondere für Matrixbildschirme, mit wenigstens einem Halbleiterbauelement (10) nach einem der Ansprüche 1 bis 11 und wenigstens einer aus mehreren Leuchtquellen (22, 24, 26), insbesondere Leuchtdioden, aufgebauten Leuchtquellenanordnung (20).

13. Verfahren zur Herstellung eines integrierten Schaltkreises mit den Schritten:

   - Aufbringen einer siliziumhaltigen Beschichtung, insbesondere einer Siliziumnitridschicht oder einer Siliziumdioxidsdhicht, mit einer ersten Schichtdicke auf eine Gruppe von Lichtdetektoren,
   - selektives Aufbringen einer siliziumhaltigen Beschichtung, insbesondere einer Siliziumnitridschicht oder einer Siliziumdioxidschicht, mit einer zweiten Schichtdicke auf eine Untergruppe aus der Gruppe der Lichtdetektoren.

14. Verfahren nach Anspruch 13, **dadurch gekennzeichnet, dass** eine siliziumhaltige Beschichtung, insbesondere eine Siliziumnitridschicht oder eine Siliziumdioxidschicht, mit einer dritten Schichtdicke auf eine Teilgruppe aus der Untergruppe von Lichtdetektoren aufgebracht wird.

Fig. 1

Fig. 2

Fig. 4

**Fig. 3**

**Fig. 5**

**IN DER BESCHREIBUNG AUFGEFÜHRTE DOKUMENTE**

**In der Beschreibung aufgeführte Patentdokumente**

- US 4131488 A
- DE 4019853 C2